Europäisches Patentamt

(19) European Patent Office

Office européen des brevets

(11) Numéro de publication: **0 277 665**
**B1**

(12) **FASCICULE DE BREVET EUROPEEN**

(45) Date de publication du fascicule du brevet:
03.10.90

(51) Int. Cl.⁵: **H03K 19/21, H03K 19/094**

(21) Numéro de dépôt: **88200004.5**

(22) Date de dépôt: **06.01.88**

(54) Circuit réalisant la fonction OU-EXCLUSIF.

(30) Priorité: **13.01.87 FR 8700263**

(43) Date de publication de la demande:
**10.08.88 Bulletin 88/32**

(45) Mention de la délivrance du brevet:
**03.10.90 Bulletin 90/40**

(84) Etats contractants désignés:
**DE FR GB IT NL**

(56) Documents cités:
**DE-A- 3 441 306**
**US-A- 4 065 680**

**PATENT ABSTRACTS OF JAPAN,**
**vol. 3, no. 2 (E-83)13 Janvier 1979, page 6 E83; &**
**JP-A-53 128 968 (FUJITSU K.K.) 11-10-1978**
**IEEE TRANSACTIONS ON MICROWAVE THEORY AND**
**TECHNIQUES, vol.**
**MTT-32, no. 1, Janvier 1984, pages 5-10, IEEE, New York,**
**US; M. IDDA et al.: "Analysis of high-speed GaAs**
**source-coupled FET logic circuits"**

(73) Titulaire: **LABORATOIRES D'ELECTRONIQUE PHILIPS,**
**3, Avenue Descartes, F-94450 Limeil-Brévannes(FR)**
(84) Etats contractants désignés: **FR**

(73) Titulaire: **N.V. Philips' Gloeilampenfabrieken,**
**Groenewoudseweg 1, NL-5621 BA Eindhoven(NL)**
(84) Etats contractants désignés: **DE GB IT NL**

(72) Inventeur: **Rocchi, Marc Société Civile S.P.I.D., 209, rue**
**de l'Université, F-75007 Paris(FR)**

(74) Mandataire: **Landousy, Christian et al, Société Civile**
**S.P.I.D. 156, Boulevard Haussmann, F-75008 Paris(FR)**

ACTORUM AG

## Description

L'invention concerne un circuit réalisant la fonction OU-EXCLUSIF entre un signal A et un signal B, réalisé au moyen de transistors à effet de champ normalement pincés en l'absence de signal grille-source et de charges, et intégré sur un substrat semiconducteur, un signal $\overline{A}$ complémentaire du signal A étant en outre appliqué à ce circuit.

L'invention concerne également un circuit réalisant la fonction OU-EXCLUSIF entre un signal A et un signal B, et générant les signaux nécessaires à son fonctionnement.

L'invention trouve son application dans la miniaturisation des circuits intégrés comprenant des portes logiques du type OU-EXCLUSIF réalisés sur substrat semiconducteur du groupe III-V, notamment en arséniure de gallium.

Une porte OU-EXCLUSIF réalisée à l'aide de transistors à effet de champ du type MESFET normalement pincés en l'absence de signal grille-source, sur un substrat en arséniure de gallium GaAs est connu de la publication "1986 IEEE gallium-arsenide integrated Circuit Symposium, Grenelefe, Florida, October 28-30, 1986" intitulée "A 0.1-4.5 GHz, 20mW GaAs Prescaler operating at 125°C" par Didier MEIGNANT, Etienne DELHAYE, Marc ROCCHI.

Le circuit décrit dans cette publication comprend pour réaliser la porte OU-EXCLUSIF six transistors à effet de champ et trois charges.

Ce nombre se monte à huit transistors et cinq charges pour réaliser en même temps le circuit complet permettant de générer les signaux d'entrée de cette porte, c'està-dire le signal complémentaire de l'un des signaux d'entrée, ce qui est fait au moyen de deux étages inverseurs supplémentaires.

Mais la demande est à ce jour pour des circuits toujours plus miniaturisés. C'est pourquoi la présente invention propose un circuit réalisant la fonction OU-EXCLUSIF réalisé dans la même technologie et formé d'un seul transistor et d'une seule charge, ainsi qu'un circuit complet permettant de générer les signaux d'entrée, qui en incluant un circuit de même structure que ce circuit OU-EXCLUSIF, ne comprend pas plus de trois transistors à effet de champ et trois charges. Ceci représente un gain de place énorme et une réduction importante de la puissance consommée par rapport à la porte OU-EXCLUSIF connue de l'état de la technique et utilisable dans les technologies de semiconducteurs du groupe III-V. Un autre avantage est que cette nouvelle porte n'augmente pas les temps de transition entre l'entrée et la sortie du circuit par rapport à l'état de la technique.

Il faut savoir que les transistors à effet de champ du type MESFET normalement pincés en l'absence de signal grille-source, réalisés sur substrat semiconducteur du groupe III-V présentent une grille passante. Du fait de cette grille non isolante, on ne peut utiliser les circuits connus en technologie silicium pour simplifier les circuits réalisant la fonction OU-EXCLUSIF. C'est pourquoi les circuits réalisés à l'aide de MESFET sont complexes et nécessitent un nombre assez grand de transistors et de charges comme il est dit plus haut.

La présente invention permet de résoudre ce problème au moyen d'un circuit tel que décrit dans le préambule, caractérisé en ce qu'il est formé d'un transistor à effet de champ $T'_1$ dont la grille est commandée par le signal B, sur le drain duquel est appliqué le signal A par l'intermédiaire d'une charge $R'_1$ et dont la source est reliée au signal $\overline{A}$ complémentaire du signal A, le signal représentant la fonction OU-EXCLUSIF (A $\oplus$ B) étant disponible au point commun entre le drain du transistor et la charge et constituant la sortie $S_1$ de ce circuit.

Selon une variante de l'invention, il est proposé un circuit réalisant la fonction OU-EXCLUSIF (OU-EXCLUSIF complémentaire = $\overline{A \oplus B}$), entre un signal A et un signal B, réalisé au moyen de transistors à effet de champ du type MESFET normalement pincés en l'absence de signal grille-source et de charges, intégré sur un substrat semiconducteur du groupe III-V, un signal $\overline{A}$ complémentaire du signal A étant en outre appliqué à ce circuit, caractérisé en ce qu'il est formé d'un transistor à effet de champ $T_1$ dont la grille est commandée

par le signal B, sur le drain duquel est appliqué le signal $\overline{A}$ complémentaire de A par l'intermédiaire d'une charge $R_1$ et dont la source est reliée au signal A, le signal représentant la fonction OU-EXCLUSIF (A ⊕ B) étant disponible au point commun entre le drain du transistor et la charge, point commun constituant la sortie $\overline{S_1}$, du circuit.

Dans une mise en oeuvre de l'invention, un circuit réalisant la fonction OU-EXCLUSIF entre un signal A et un signal B, générant les signaux nécessaires à son fonctionnement est caractérisé en ce qu'il comprend un circuit réalisant la fonction OU-EXCLUSIF (A + B) du type précédent, en ce que le signal $\overline{A}$ complémentaire du signal A nécessaire à ce circuit est généré par un premier étage inverseur et en ce que le signal de sortie du circuit OU-EXCLUSIF est porté sur l'entrée d'un second étage inverseur, la sortie générale du circuit se faisant à la sortie du second étage inverseur et représentant la fonction OU-EXCLUSIF (A ⊕ B).

Dans une réalisation particulière, ce dernier circuit est caractérisé en ce que chaque étage inverseur est formé d'un transistor à effet de champ du type MESFET normalement pincé en l'absence de signal grille-source dont la grille est commandée par le signal d'entrée, A pour le premier

et OU-EXCLUSIF pour le second, dont la source est à la masse et dont le drain est relié à l'alimentation continue à

travers une charge, le signal de sortie, $\overline{A}$ pour le premier et OU-EXCLUSIF pour le second, étant disponible au point commun entre le drain et la charge.

L'invention sera mieux comprise au moyen de la description suivante, illustrée par les figures annexées, dont :

- la figure 1a qui représente la porte OU-EXCLUSIF selon l'invention et la figure 1b qui représente la porte OU-EXCLUSIF ;

- la figure 2 qui représente le circuit complet permettant de générer les signaux nécessaires au fonctionnement de la porte et incluant une porte OU-EXCLUSIF ;

- la figure 3 qui représente le séquencement des signaux.

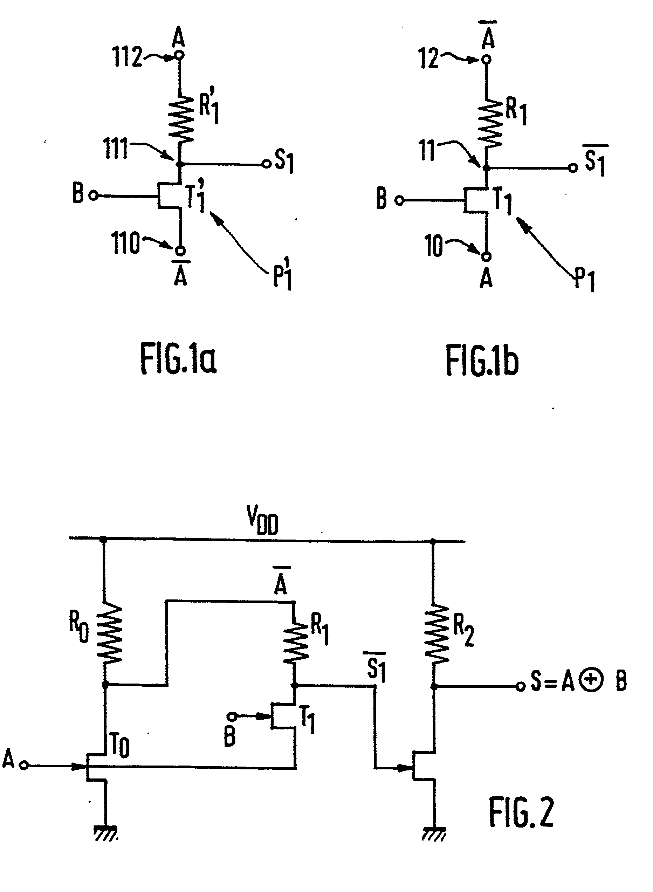

Telle que représentée sur la figure 1a, la porte OU-EXCLUSIF $P'_1$ selon l'invention est formée d'un transistor à effet de champ $T'_1$ du type MESFET, normalement pincé en l'absence de signal grille-source. La grille de ce transistor $T'_1$ est commandée par un signal, par exemple B. La source de ce transistor $T'_1$ est reliée à une borne 110 sur laquelle est appliqué un second signal par exemple $\overline{A}$ complémentaire d'un signal A. Le drain 111 du transistor $T'_1$ est relié à une borne 112 sur laquelle est appliqué le signal A par l'intermédiaire d'une charge $R'_1$. La sortie $S_1$ de la porte est disponible sur la borne 111 et est telle qu'elle transporte le signal représentant la fonction OU-EXCLUSIF :
$S_1 = A ⊕ B$
En effet une porte OU-EXCLUSIF est telle qu'elle peut fournir les états représentés par le tableau I :

## TABLEAU I

| A | B | $S_1 = A \oplus B$ |
|---|---|---|
| 0 | 0 | 0 |
| 0 | 1 | 1 |
| 1 | 0 | 1 |
| 1 | 1 | 0 |

Ce qui est bien le cas pour la porte représentée sur la figure 1a.

Tel que représenté sur la figure 1b, le circuit P$_1$ réalise alors la fonction OU-EXCLUSIF (OU-EXCLUSIF complémentaire = $\overline{A \oplus B}$). Le circuit P$_1$ est formé d'une structure identique au circuit P'$_1$ précédemment décrit. Il comporte en effet un transistor à effet de champ T$_1$, du type MESFET normalement pincé en l'absence de signal grille-source. La grille du transistor T$_1$ est commandée par le signal B. La source du transistor T$_1$ est reliée à une borne 10 sur laquelle est appliqué le signal A. Le drain 11 du transistor T$_1$ est relié à la borne 12 sur laquelle est appliqué le signal $\overline{A}$ complémentaire du signal A par l'intermédiaire d'une charge R$_1$. La sortie S$_1$ de ce circuit est disponible sur la borne 11 et est telle qu'elle transporte le signal OU-EXCLUSIF.

$$S_1 = \overline{A} \oplus B$$

Le circuit P$_1$ est donc similaire au circuit P'$_1$, mais les signaux A et son complémentaire $\overline{A}$ sont inversés. Dans ces conditions la sortie est aussi inversée.

Dans le but de générer le signal $\overline{A}$ complémentaire du signal A nécessaire à produire la fonction voulue, et dans le but de réaliser un circuit OU-EXCLUSIF capable d'avoir une sortance d'au moins 4, la porte de la figure 1b est incorporée dans le circuit représenté figure 2.

Tel que représenté sur la figure 2, un tel circuit OU-EXCLUSIF comprend un premier étage inverseur formé d'un transistor à effet de champ T$_0$ du type MESFET normalement pincé en l'absence de signal grille-source. Ce transistor inverseur T$_0$ montre une grille commandée par le signal A, une source reliée à la masse, un drain relié à une alimentation continue V$_{DD}$ par l'intermédiaire d'une charge R$_0$. Le signal $\overline{A}$ complémentaire de A est disponible au point commun entre le drain du transistor inverseur T$_0$ et sa charge R$_0$, et est porté sur la borne 12 de la porte OU-EXCLUSIF P$_1$.

D'autre part, la sortie S$_1$ de la porte P$_1$ est portée sur la grille d'un transistor T$_2$ inverseur, dont la source est reliée à la masse et dont le drain est porté à l'alimentation continue V$_{DD}$ par l'intermédiaire d'une charge R$_2$. La sortie de ce second étage inverseur fournit la sortie générale S du circuit sur laquelle est disponible le signal OU-EXCLUSIF A $\oplus$ B.

Selon l'invention, le circuit de la figure 2 est donc aussi rapide que le circuit connu de l'état de la technique, mais il est formé d'un nombre bien inférieur d'éléments, puisqu'il ne comprend que trois transistors et trois charges au lieu de huit transistors et cinq charges.

Les charges peuvent être aussi bien du type résistif que formées de transistors à effet de champ.

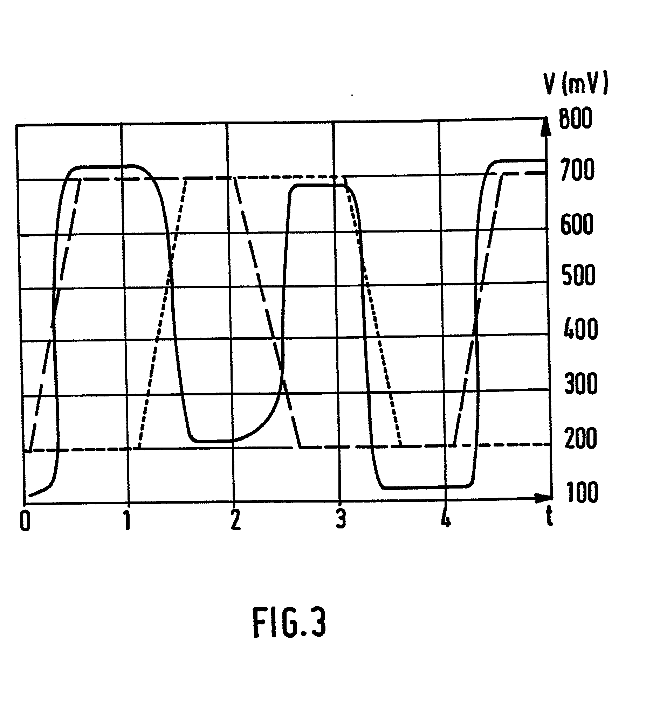

La figure 3 montre un exemple de séquencement de signaux, la courbe en petits traits discontinus figurant le signal A, la courbe en grands traits discontinus le signal B, et la courbe en trait continu le signal de sortie S.

On constate que la sortie est bien à l'état bas lorsque à la fois A et B sont à l'état haut, ou à la fois A et B sont à l'état bas, la sortie étant à l'état haut dans les autres cas.

Le tableau II donne les valeurs R des résistances et les largeurs L de grille des transistors dans un exemple de réalisation où les transistors à effet de champ sont en arséniure de gallium avec :
- l'alimentation continue $V_{DD}$ = 1,2 volt,
- les tensions de seuil des transistors $V_T$ = 100 mV,
- les longueurs de grille des transistors $\ell$ = 0,7μm,
et où les charges sont de type résistif.

## TABLEAU II

| Transistors | L (μm) | Résistance | R(kΩ) |
|---|---|---|---|
| $T_0$ | 20 | $R_0$ | 2 |
| $T_1$ | 20 | $R_1$ | 4 |
| $T_2$ | 30 | $R_2$ | 2 |

**Revendications**

1 .Circuit réalisant la fonction OU-EXCLUSIF entre un signal A et un signal B, réalisé au moyen de transistors à effet de champ normalement pincés en l'absence de signal grille-source et de charges, et intégré sur un substrat semiconducteur, un signal complémentaire $\overline{A}$ du signal A étant en outre appliqué à ce circuit, caractérisé en ce qu'il est formé d'un transistor à effet de champ $T'_1$ dont la grille est commandée par le signal B, sur le drain duquel est appliqué le signal A par l'intermédiaire d'une charge $R'_1$ et dont la source est reliée au signal $\overline{A}$ complémentaire du signal A, le signal représentant la fonction OU-EXCLUSIF (A ⊕ B) étant disponible au point commun entre le drain du transistor $T'_1$ et la charge $R'_1$ et constituant la sortie $S_1$ de la porte.

2. Circuit réalisant la fonction $\overline{OU-EXCLUSIF}$ (OU-EX-CLUSIF complémentaire = A ⊕ B) entre un signal A et un signal B, réalisé au moyen de transistors à effet de champ normalement pincés en l'absence de signal grille-source et de charges, intégré sur un substrat semiconducteur, un signal $\overline{A}$ complémentaire du signal A étant en outre appliqué à ce circuit, caractérisé en ce qu'il est formé d'un transistor à effet de champ $T_1$ dont la grille est commandée par le signal B, sur le drain duquel est appliqué le signal $\overline{A}$ complémentaire de A par l'intermédiaire d'une charge $R_1$ et dont la source est reliée au signal A, le signal représentant la fonction $\overline{OU-EXCLUSIF}$ (A ⊕ B) étant disponible au point commun entre le drain du transistor et la charge, point commun constituant la sortie $S_1$ du circuit.

3. Circuit réalisant la fonction OU-EXCLUSIF entre un signal A et un signal B, générant les signaux nécessaires à son fonctionnement, caractérisé en ce qu'il comprend un

5

circuit réalisant la fonction OU-EXCLUSIF selon la revendication 2, en ce que le signal $\overline{A}$ complémentaire du signal A est généré par un premier étage inverseur et en ce que le signal de sortie du circuit OU-EXCLUSIF est porté sur l'entrée d'un second étage inverseur, la sortie générale du circuit se faisant à la sortie du second étage inverseur et représentant la fonction OU-EXCLUSIF (A ⊕ B).

4. Circuit selon la revendication 3, caractérisé en ce que chaque étage inverseur est formé d'un transistor à effet de champ normalement pincé en l'absence de signal grille-source dont la grille est commandée par le signal d'entrée, A pour le premier et $A \oplus B$ pour le second, dont la source est à la masse et dont le drain est relié à l'alimentation continue à travers une charge, le signal de sortie, $\overline{A}$ pour le premier et A ⊕ B pour le second étant disponible au point commun entre le drain et la charge.

5. Circuit selon l'une des revendications 1 à 4, caractérisé en ce que les charges sont du type résistif.

**Patentansprüche**

1. Schaltung zur Durchführung der Exklusiv-ODER-Funktion zwischen einem Signal A und einem Signal B, wobei diese Schaltung mit selbstsperrenden Feldeffekttransistoren und Belastungen verwirklicht und auf einem Halbleitersubstrat integriert worden ist, wobei dieser Schaltung ebenfalls ein Komplement $\overline{A}$ des Signals A zugeleitet wird, dadurch gekennzeichnet, daß die Schaltung einen Feldeffekttransistor $T'_1$ enthält, dessen Gate vom Signal B gesteuert wird, an dessen Drain das Signal A über eine Belastung $R'_1$ gelangt und dessen Source des Komplement $\overline{A}$ des Signals A führt, wobei das die Exklusiv-ODER-Funktion darstellende Signal (A ⊕ B) am gemeinsamen Punkt zwischen dem Drain des Transistors $T'_1$ und der Belastung $R'_1$ zur Verfügung steht und das Ausgangssignal $S_1$ des Tores bildet.

2. Schaltung zur Durchführung der Exklusiv-ODER-Funktion (Exklusiv-ODER-Komplement = $\overline{A \oplus B}$) zwischen einem Signal A und einem Signal B, wobei diese Schaltung mit selbstsperrenden Feldeffekttransistoren und Belastungen verwirklicht und auf einem Halbleitersubstrat integriert worden ist, wobei dieser Schaltung ebenfalls ein Komplement $\overline{A}$ des Signals A zugeleitet wird, dadurch gekennzeichnet, daß die Schaltung einen Feldeffekttransistor $T_1$ enthält, dessen Gate vom Signal B gesteuert wird, an dessen Drain das Komplement A des Signals A über eine Belastung $R_1$ gelangt und dessen Source das Komplement $\overline{A}$ des Signals A führt, wobei das die Exklusiv-ODER-Funktion darstellende Signal $\overline{(A \oplus B)}$ am gemeinsamen Punkt zwischen dem Drain des Transistors und der Belastung zur Verfügung steht, wobei der gemeinsame Punkt das Ausgangssignal $\overline{S_1}$ des Tores bildet.

3. Schaltung zur Durchführung der Exklusiv-ODER-Funktion zwischen einem Signal A und einem Signal B, die für ihren Betrieb die erforderlichen Signale erzeugt, dadurch gekennzeichnet, daß sie eine Exklusiv-ODER-Schaltung nach Anspruch 2 verwirklicht, daß das Komplement $\overline{A}$ des Signals A von einer ersten Umkehrstufe erzeugt wird und daß das Ausgangssignal der Exklusiv-ODER-Schaltung dem Eingang einer zweiten Umkehrstufe zugeleitet wird, wobei das allgemeine Ausgangssignal der Schaltung am Ausgang der zweiten Umkehrstufe zur Verfügung steht und die Exklusiv-ODER-Funktion (A ⊕ B) darstellt.

4. Schaltung nach Anspruch 3, dadurch gekennzeichnet, daß jede Umkehrstufe von einem selbstsperrenden Feldeffekttransistor gebildet wird, dessen Gate vom Eingangssignal gesteuert wird, d.h. A für die erste und $\overline{A \oplus B}$ für die zweite Stufe, dessen Source an Masse liegt und dessen Drain mit der Gleichspannungsspeisung über eine Belastung verbunden ist, wobei das Ausgangssignal, d.h. $\overline{A}$ für die

erste und A ⊕ B für die zweite Stufe, am gemeinsamen Punkt zwischen dem Drain und der Belastung zur Verfügung steht.

5. Schaltung nach einem der Ansprüche 1 bis 4, dadurch gekennzeichnet, daß die Belastungen vom Widerstandstyp sind.

## Claims

1. A circuit for performing the EXCLUSIVE-OR function of a signal A and a signal B, which circuit is realized by means of field effect transistors normally - off in the absence of a gate-source signal and by means of loads, and is integrated on a semiconductor substrate, a signal $\overline{A}$ which is complementary to the signal A also being applied to this circuit, characterized in that the circuit is formed by a field effect transistor T'$_1$ whose gate is controlled by the signal B, whose drain receives the signal A via a load R'$_1$,

and whose source receives the signal $\overline{A}$ which is complementary to the signal A, the signal representing the EXCLUSIVE-OR function (A ⊕ B) being available at the junction of the drain of the transistor T'$_1$ and the load R'$_1$ and constituting the output S$_1$ of the gate.

2.    A circuit for performing the $\overline{\text{EXCLUSIVE-OR}}$

function (complementary EXCLUSIVE-OR = $\overline{A \oplus B}$ ) of

of a signal A and a signal B, which circuit is realized by means of field effect transistors normally - off in the absence of a gate-source signal and by means of loads, and is integrated on a semiconductor substrate, a signal $\overline{A}$ which is complementary to the signal A also being applied to this circuit, characterized in that the circuit is formed by a field effect transistor T$_1$ whose gate is controlled by the signal B, whose drain receives the signal $\overline{A}$ which is complementary to the signal A via a load R$_1$, and whose source receives the signal A, the signal representing the

$\overline{\text{EXCLUSIVE-OR}}$ function ($\overline{A \oplus B}$) being available at the junction of the drain of the transistor and the load, which junction constitutes the output $\overline{S_1}$ of the circuit.

3. A circuit for performing the EXCLUSIVE-OR function of a signal A and a signal B and generating the signals necessary for its operation, characterized in that it comprises a circuit for performing the

$\overline{\text{EXCLUSIVE-OR}}$ function as claimed in Claim 2, the

signal $\overline{A}$ which is complementary to the signal A being generated by a first inverter stage, the output signal

of the $\overline{\text{EXCLUSIVE-OR}}$ circuit being applied to the input

of a second inverter stage, the overall output of the circuit being formed by the output of the second inverter stage and representing the EXCLUSIVE-OR function (A ⊕ B).

4. A circuit as claimed in Claim 3, characterized in that each inverter stage is formed by a field effect transistor which is normally cut off in the absence of a gate-source signal and whose gate is controlled by the input signal, being A for the first

inverter stage and $\overline{A \oplus B}$ for the second inverter stage,

its source being connected to ground and its drain receiving the d.c. supply voltage via a load, the out-

put signal, being $\overline{A}$ for the first inverter stage and $A \oplus B$ for the second inverter stage, being available at the junction of the drain and the load.

5. A circuit as claimed in one of the Claims 1 to 4, characterized in that the loads are of the resistive type.

FIG.1a

FIG.1b

$S = A \oplus B$

FIG.2

FIG.3